(19) Europäisches Patentamt
European Patent Office
Office européen des brevets

(11) **EP 3 125 343 B1**

(12) **FASCICULE DE BREVET EUROPEEN**

(45) Date de publication et mention de la délivrance du brevet:
**02.05.2018 Bulletin 2018/18**

(21) Numéro de dépôt: **16178931.8**

(22) Date de dépôt: **12.07.2016**

(51) Int Cl.:
*H01M 6/50* (2006.01)          *H01M 6/36* (2006.01)
*B64C 27/00* (2006.01)        *B64D 35/08* (2006.01)
*B64D 41/00* (2006.01)

(54) **STOCKAGE D'ENERGIE A PILES THERMIQUES POUR AERONEF A VOILURE TOURNANTE**

ENERGIESPEICHERUNG IN THERMALBATTERIEN FÜR DREHFLÜGELFLUGZEUG

THERMOPILE ENERGY STORAGE FOR A ROTARY WING AIRCRAFT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2015 FR 1501643**

(43) Date de publication de la demande:
**01.02.2017 Bulletin 2017/05**

(73) Titulaire: **Airbus Helicopters**
**13725 Marignane Cedex (FR)**

(72) Inventeur: **CONNAULTE, Matthieu**
**13680 LANCON DE PROVENCE (FR)**

(74) Mandataire: **Pouillot, Laurent Pierre Paul**
**GPI & Associés**
**1330, Rue Guillibert de la Lauzière**
**EuroParc de Pichaury, Bât B2**
**13856 Aix-en-Provence Cedex 3 (FR)**

(56) Documents cités:
**FR-A1- 2 994 687**

• **Anonymous: "ASB - domaines de performance des piles Thermiques", , 18 mai 2014 (2014-05-18), XP055279373, Extrait de l'Internet: URL:https://web.archive.org/web/2014051817 2333/http://www.asb-group.com/domaine-perf ormance.asp [extrait le 2016-06-09]**

**Description**

L'invention se situe dans le domaine technique des installations électriques d'aéronefs à voilures tournantes. Plus spécifiquement, l'invention concerne le stockage d'énergie pour de telles installations électriques.

Un aéronef à voilure tournante est classiquement pourvu d'au moins un rotor principal pour assurer sa sustentation voire sa propulsion et généralement d'un rotor arrière anticouple pour notamment s'opposer au couple en lacet exercé par le rotor principal sur le fuselage de l'aéronef ou pour aussi permettre de contrôler des mouvements en lacet de l'aéronef.

Afin d'entraîner en rotation le rotor principal et le rotor arrière, l'aéronef comporte une installation motrice qui peut comporter un ou plusieurs moteurs thermiques.

Il est à noter que l'on entend dans l'ensemble du texte par « moteur thermique » les turbomoteurs ou encore l'ensemble des moteurs à pistons pouvant être utilisés dans une telle installation motrice. L'expression « moteur thermique » est à opposer à l'expression « moteur électrique » qualifiant les moteurs mus par une puissance électrique.

Par ailleurs, dans le domaine général des stockages d'énergie électrique, les piles thermiques sont connues.

Ainsi, le document EP1059134 décrit des piles thermiques qui sont ainsi principalement utilisées dans l'industrie aéronautique et spatiale ou dans des systèmes d'urgence et de secours qui requièrent une source fiable d'énergie de réserve par exemple dans l'industrie nucléaire, pétrolière, le bâtiment. Les piles thermiques sont des piles non rechargeables, inertes avant leur amorçage, qui peuvent être stockées sans entretien pendant parfois plus de 20 ans tout en restant utilisables à tout instant avec un temps de réponse parfois inférieur à quelques dixièmes de seconde. Les piles thermiques voient leur utilisation croître dans tous les domaines où l'on a besoin d'une énergie immédiatement disponible, de manière fiable, même après un temps de stockage très long. Ces piles thermiques incorporent une poudre de métal, par exemple une poudre de fer préparée qui présente une structure spongieuse et filamenteuse. Cette poudre est utilisée dans les compositions chauffantes pour piles thermiques.

Divers documents proposent d'intégrer une ou plusieurs piles thermiques au stockage d'énergie d'un aéronef à voilure tournante.

Le document FR2994687 qui est considéré comme le document de l'art antérieur le plus proche, décrit une assistance d'un pilote d'aéronef à voilure tournante lors d'une phase de vol en autorotation. L'aéronef comporte une installation motrice hybride munie d'un moteur thermique, d'au moins une machine électrique et d'une boîte de transmission principale de puissance. Un stockage d'énergie électrique à bord comporte par exemple un condensateur capable de fournir une puissance importante dans un temps limité de type super-capacité, une pile thermique qui nécessite un apport de chaleur pour fournir une puissance, ou bien une batterie rechargeable. Le rotor principal est entraîné, en vol, à une vitesse nominale de rotation par l'installation motrice hybride, c'est-à-dire composée d'au moins un moteur thermique et d'au moins un moteur électrique, de sorte que durant une étape de surveillance en vol un paramètre de surveillance est mesuré afin de détecter une éventuelle panne du moteur thermique. Lorsqu'une panne est détectée, on commande le moteur électrique pour fournir une puissance auxiliaire au rotor principal, permettant ainsi d'assister le pilote lors d'un vol en autorotation consécutive à la panne, rendant possible une marge de manoeuvre additionnelle de l'aéronef.

Le document FR2997382 décrit un contrôle en vol du fonctionnement de moteurs thermiques d'un aéronef à voilure tournante, par l'intermédiaire d'un boîtier électronique de contrôle EECU, afin de détecter une éventuelle panne de moteur. Un moteur thermique est considéré en panne lorsqu'au moins un autre moteur thermique met en oeuvre des puissances d'urgence. La surveillance détermine une valeur de surveillance d'un paramètre de l'aéronef et un seuil de détection de déficit de puissance totale. Puis une comparaison de la valeur de surveillance avec le seuil de détection identifie un risque de déficit de puissance totale. Ce déficit apparait dès qu'au moins un moteur thermique doit fournir une puissance supérieure à une puissance prédéterminée. Une commande intervient si une panne est détectée avec le seuil dépassé, pour qu'une puissance auxiliaire suffisante soit fournie pour la manoeuvre de l'aéronef en sécurité, e.g. avec chaque moteur thermique ne fournissant pas une puissance supérieure à la puissance prédéterminée. Par exemple, le moyen de stockage comporte au moins une batterie rechargeable, une pile thermique ou bien une super-capacité.

Il pourrait également être intéressant d'employer une ou plusieurs piles thermiques pour des installations motrices d'aéronefs à voilures tournantes, telles que celle du document FR2952907. L'installation motrice est munie d'un unique moteur de puissance thermique ainsi que d'une boîte de transmission principale (BTP) apte à entraîner la voilure tournante et d'une boîte de transmission arrière (BTA) apte à entraîner un rotor anticouple. L'installation comporte un premier moteur électrique mécaniquement lié à la boîte de transmission principale et un deuxième moteur électrique mécaniquement lié à la boîte de transmission arrière (BTA).

Le document WO2012059671 décrit un hélicoptère équipé de deux turbomoteurs et d'un système de régulation. Les deux turbomoteurs sont équipés chacun d'un générateur de gaz et d'une turbine libre et de moyens aptes à activer le générateur de gaz en sortie d'un régime sur-ralenti. Des moyens d'entraînement en rotation, des moyens d'accélération du générateur de gaz et des moyens de mise à feu à effet quasi-instantané sont prévus dans l'architecture. Ces derniers sont complémentaires d'un dispositif d'assistance mécanique d'urgence avec une source d'énergie autonome embarquée. La mise à feu à effet quasi-instantanée est prévue en fonction des conditions et des phases de vol de l'hélicoptère selon un profil de mission, par exemple lors de régimes transitoires ou en cas de panne du moteur utilisé en réactivant l'autre moteur. Par exemple lorsqu'un turbomoteur surdimensionné utilisé en fonctionnement seul pendant des phases de vol de croisière tombe en panne, un autre petit moteur est rapidement réactivé via son dispositif d'assistance d'urgence. L'équipement électrique propre à ce générateur, le démarre et l'accélère jusqu'à ce que sa vitesse de rotation soit dans une fenêtre d'allumage de la chambre puis, une fois la chambre allumée, le générateur de gaz est de nouveau accéléré classiquement. En régime de sur-ralenti en chambre éteinte, une mise à feu complémentaire de la chambre de combustion, c'est-à-dire en plus d'une mise à feu conventionnelle, peut être déclenchée.

De plus, le document XP055279373 «ASB - domaines de performance des piles Thermiques» décrit un diagramme permettant de visualiser l'état actuel d'un domaine de performance de piles thermiques. Ce document décrit des intervalles de valeurs pour des piles thermiques, avec une puissance allant jusqu'à 9 kW, avec 25 kW en impulsions, une énergie spécifique jusqu'à 120 Wh/kg associée à des forts taux de décharge, une durée de fonctionnement 0,5 seconde à 2 heures et une durée d'activation à partir de 30 millisecondes.

De ce qui précède, il ressort qu'il serait utile pour l'amélioration des installations motrices, et avec une spécification de pile(s) thermique(s) raisonnable, de rendre disponible une puissance utile suffisante pour des conditions et phases de vol de qui risquent de survenir dans certaines missions.

En outre, il pourrait être intéressant d'employer une ou plusieurs piles thermiques pour d'autres équipements de bord d'aéronefs à voilures tournantes, que les installations motrices, mais le stockage d'énergie électrique est un des principaux freins à l'électrification de ces aéronefs

Plus généralement, l'utilisation de l'énergie électrique pour les aéronefs à voilures tournantes apporte plusieurs avantages, notamment en termes d'apport d'énergie de réserve dans certaines phases de vol critique telles qu'une panne d'un moteur ou des situations d'urgence lors desquelles le maintien de fonctions de secours augmente la sécurité de l'aéronef.

De plus, le durcissement des normes de sécurité de vol, d'émission de polluants et de réduction des nuisances sonores milite en faveur de ce type d'énergie. De même, pour des équipements de bord tels que les commandes de vol, il est de plus en plus courant de recourir à des dispositifs électriques, pour des raisons de simplification de conception et de maintenance, de masse et d'encombrement, notamment.

Par suite, l'électrification des aéronefs à voilure tournante intégrant des piles thermiques est prometteuse.

Cependant, les batteries sont lourdes, voire très lourdes si une grande quantité d'énergie électrique doit être stockée, et les super-capacités ne peuvent fournir une puissance électrique importante que pendant un temps très limité.

Bien que les piles thermiques soient à usage unique et aient une durée de fonctionnement limitée après activation, leur intégration paraît favorable pour certaines applications dans le domaine des aéronefs à voilures tournantes.

En pratique, toutefois, plusieurs problèmes techniques se posent lorsqu'une ou plusieurs piles thermiques sont intégrées au stockage d'énergie d'un aéronef à voilure tournante.

Ainsi, l'intégration de piles thermiques au stockage d'énergie d'un aéronef à voilure tournante implique une protection thermique qui permette le maintien de ces piles dans une plage de températures garantissant une fourniture optimale d'énergie au moment utile, tout en évitant que les structures connexes au stockage d'énergie de l'aéronef ne risquent d'être exposées à des échauffements trop importants. Par exemple, les matériaux composites qui sont de plus en plus présents dans ces aéronefs, présentent des propriétés mécaniques optimales qu'en dessous de certaines températures.

Par exemple, les piles thermiques comportent en général des dispositifs de déclenchement en général pyrotechniques, qui sont mis en oeuvre électriquement lors de l'activation des piles. Il convient donc de maîtriser les élévations de températures dues à ces dispositifs.

Aussi, la maîtrise des températures des piles thermiques doit pouvoir maintenir ces piles dans une plage de températures relativement limitée durant chaque durée de fourniture prévue, afin que des quantités d'énergie appropriées puissent être disponibles au moment opportun.

Par ailleurs, avant l'activation, les piles présentent une résistance électrique très importante qui se mesure en mégohms. Par contre, après l'activation, les piles présentent une résistance minime qui se mesure en dixièmes d'ohm.

Dans un circuit électrique comportant un système de stockage d'énergie, il est courant d'utiliser des convertisseurs d'énergie comprenant des étages de filtrage du courant de type capacitif. Il se produit alors, au moment de la mise en marche du dispositif de stockage, un fort appel de courant électrique qui charge ces capacités pouvant dégrader certains éléments de la chaine du circuit électrique, notamment les contacteurs de puissance. Il convient alors d'utiliser un circuit de pré-charge dédié, comprenant un contacteur et une résistance en série, afin de limiter les surcourants d'appel. Ces circuits supplémentaires alourdissent l'installation électrique embarquée, la rendent plus complexe et ont un coût non négligeable. L'utilisation d'une pile thermique permet d'éviter le contacteur de puissance ainsi que le circuit de pré-charge car le courant est limité automatiquement lors de l'activation par la résistance interne de la pile qui décroit de manière continue et suffisamment lente.

Un problème technique posé par l'intégration de piles thermiques à des aéronefs à voilures tournantes est de pouvoir déterminer les spécifications impliquant ces piles thermiques de façon simple, précise et sans surcoûts ou surpoids délétères à l'aéronef dans son ensemble.

Ainsi, dans le cas d'une intégration de piles thermiques à un aéronef à voilure tournante, le calcul préalable des valeurs de temps de mise en oeuvre des piles thermiques, leur durée d'apport et les valeurs de puissance de ces piles, est complexe mais conditionne en partie l'intérêt de cette intégration.

Il est précisé que l'invention ne se limite pas à la fourniture en cas d'urgence de puissance destinée à la motorisation, mais permet également de satisfaire des besoins d'énergie électrique d'urgence pour le maintien de fonctions de secours dans l'aéronef.

Dans le même ordre d'idées, l'anticipation des paramètres de réactivité des piles thermiques à intégrer à un aéronef à voilure tournante est essentielle, et ces paramètres doivent être choisis avec précision dès la conception de l'aéronef. Ainsi, pour une intégration efficace de piles à un aéronef à voilure tournante, il est nécessaire de détailler des valeurs de puissance utiles et des intervalles de temps précis.

De plus, une intégration de piles thermiques à un aéronef à voilure tournante implique de déterminer la durée de détection des besoins d'énergie à satisfaire par ces piles, la durée de déclenchement des piles, leur durée nécessaire de fourniture de puissance suffisante, ainsi que les durées de réponse des équipements alimentés par les piles thermiques. Ces durées sont complexes à anticiper avec précision car ceci implique de prendre en considération dès la conception de l'aéronef des données nombreuses et variées, propres au fonctionnement et aux divers environnements d'opération de l'aéronef.

Dans ce contexte, quel que soit le moyen de stockage de l'énergie électrique, la quantité d'énergie électrique disponible reste limitée alors que la masse de ce moyen de stockage de l'énergie électrique peut être importante.

De la sorte, le gain de performance que pourrait permettre d'obtenir l'utilisation d'une ou plusieurs piles thermiques au sein de l'installation motrice d'un aéronef se heurte à plusieurs limitations, propres à ces piles mais également liées au stockage de l'énergie électrique. Il faut par exemple trouver un équilibre entre le gain de performance de l'installation électrique et l'augmentation de masse générée par l'utilisation de ces moyens de stockage de l'énergie électrique nécessaire au fonctionnement cherché de l'aéronef.

Dans ce but, un objet de l'invention vise un procédé de configuration d'un aéronef à voilure tournante, cet aéronef à voilure tournante intégrant une installation électrique et des équipements consommateurs d'énergie électrique, cette installation électrique comportant au moins une pile thermique et étant apte à délivrer à la demande une quantité prédéterminée d'énergie électrique à au moins un équipement consommateur;

Selon l'invention, le procédé de configuration comporte au moins une étape de définition de spécifications techniques de ladite au moins une pile thermique et de l'installation électrique, en termes opérationnels, structurels et d'agencement au sein de l'aéronef à voilure tournante, ces spécification techniques comprenant:

- une puissance utile à fournir par ladite au moins une pile thermique en fonction de la quantité d'énergie électrique à délivrer par l'installation électrique pour au moins ledit équipement consommateur, cette puissance utile étant prédéterminée entre 20 Watts et 200 kilowatts,
- un laps de temps de montée en puissance de ladite au moins une pile thermique, jusqu'à au moins la quantité prédéterminée d'énergie électrique, ce laps de temps étant compris entre quelques dixièmes de secondes et 3 secondes
- un temps de disponibilité lors duquel ledit équipement consommateur ne requiert pas d'énergie mais ladite au moins une pile thermique reste chaude pour une utilisation à tout moment, ce temps de disponibilité étant compris entre 10 et 300 secondes, et.
- un temps de fonctionnement de fourniture utile de la quantité prédéterminée d'énergie électrique à au moins ledit équipement consommateur par ladite au moins une pile thermique, ce temps de fonctionnement pouvant aller jusqu'à la durée de disponibilité, en fonction de la puissance délivrée.

Selon l'invention, l'étape de définition de spécifications techniques comporte au moins une routine de maximisation de la quantité de puissance utile fournie $P_{charge}(t)$ en fonction du temps t lors de l'activation de ladite au moins une pile thermique, cette routine de maximisation commandant un fonctionnement électrique à adaptation d'impédance dudit au moins un équipement consommateur ou charge, la routine de maximisation prévoyant que ladite au moins une pile thermique équivaut, selon un modèle de conversion de Thévenin, à un circuit électrique linéaire en boucle, auquel s'applique en série la résistance $R_{pile}$ de la pile et la résistance $R_{charge}$ de l'équipement, une force électromotrice $FEM_{pile}$ de la pile, une intensité $I_{pile}(t)$ du courant électrique et une tension électrique de charge $U_{charge}(t)$ de l'équipement , cette routine de maximisation déterminant une valeur de la tension de charge $U_{charge}(t)$ qui annule la dérivée:

$$\frac{dP_{charge}(t)}{dI_{charge}(t)} = FEM_{pile} - 2 * R_{pile}(t) * I_{charge}(t) = 0$$

de sorte que la tension de charge $U_{charge}(t)$ est atteinte lorsque la résistance $R_{charge}$ de l'équipement égale la résistance $R_{pile}$ de la pile formant source. Selon l'invention, la routine de maximisation adapte ladite tension de charge $U_{charge}(t)$ pour obtenir :

$$U_{charge}(t) = \frac{FEM_{pile}}{2}$$

Selon une réalisation, le procédé comprend une règle d'évaluation, après activation, de la quantité d'énergie électrique disponible auprès de ladite au moins une pile thermique lors de son fonctionnement, sur la base de l'énergie initiale dans la pile $E_{initiale}$, la puissance maximale demandée $P_{max}$, le temps de fonctionnement $T_{fonctionnement.max}$ à la puissance $P_{max}$, limité par exemple en fonction d'au moins une valeur thermique, qui sont obtenues lors de l'étape de définition de spécifications techniques, et à partir d'un instant d'activation mesuré $t_{activation}$ du début de l'activation, d'un instant courant $t_{courant}$ mesuré et d'une puissance courante délivrée $P_{delivree}(t)$ mesurée à l'instant courant $t_{courant}$, telle que :

$$P_{delivree}(t) = U_{charge}(t_{courant}) * I_{charge}(t_{courant})$$

Ladite règle d'évaluation de la quantité d'énergie électrique disponible lors du fonctionnement de ladite au moins une pile thermique, fournit une valeur en pourcentage T% d'énergie à l'instant courant $t_{courant}$ à partir de l'énergie restante $E_{restante}$ dans la pile. Cette énergie restante $E_{restante}$ est obtenue par dérivation de l'énergie initiale $E_{initiale}$ dans la pile, dérivée de l'instant d'activation mesuré $t_{activation}$ à l'instant courant $t_{courant}$ pour une puissance délivrée $P_{délivrée}(t)$ à cet instant courant $t_{courant}$, où $P_{delivree}(t) = U_{charge}(t_{courant}) * I_{charge}(t_{courant})$ et selon la formule suivante:

$$E_{restante} = E_{initiale} - \int_{t_{activation}}^{t} P_{délivrée}(t)dt.$$

Puis, à partir de l'énergie $E_{restante}$, ladite règle d'évaluation détermine le temps « $T_{restant\ à\ puissance\ P}$ » en fonction de la puissance P qui est la puissance mesurée à l'instant courant $t_{courant}$ et d'un temps de fonctionnement« $T_{fonctionnement\ max}$ » à puissance maximale qui est propre à la pile telle que dimensionnée. Dès lors, ladite règle d'évaluation calcule la valeur T% de l'énergie, à partir de la formule suivante

$$T_{restant\ à\ puissance\ P} = \frac{E_{restante}}{P}$$

de sorte que la valeur T% de l'énergie est :

$$T\% = \frac{T_{restant\ à\ puissance\ P}}{T_{fonctionnement.max}} \times 100.$$

Selon une réalisation, le procédé comporte une loi de contrôle de réduction d'impédance La technologie de ladite au moins une pile thermique est telle qu'à l'activation, la résistance interne de cette pile thermique diminue progressivement. En effet, les sels de l'électrolyte deviennent peu à peu liquides en chauffant et permettent le passage d'un courant de plus en plus important vers l'installation électrique. Selon une réalisation, la loi de contrôle de réduction d'impédance est mise en exécution par exemple par un agencement de contrôle électrique intégré à l'aéronef à voilure tournante.

Suivant cette loi de contrôle de réduction d'impédance, l'agencement de contrôle électrique scrute la résistance interne pendant la durée de diminution de résistance qui est comprise entre 100ms et 3 secondes. Cette loi permet de vérifier que le courant électrique d'appel d'une électronique de puissance du convertisseur de l'installation électrique est convenable. Dès lors, cette installation ne comporte pas de résistance de pré-charge à fonction de limitation de ce courant d'appel.

Selon une réalisation, le procédé comporte une procédure de surveillance thermique de ladite au moins une pile thermique et une procédure de protection thermique de maintien de ladite au moins une pile thermique dans une plage de températures garantissant une fourniture optimale d'énergie tout en évitant que les structures de l'aéronef à voilure tournante, connexes à ladite au moins une pile thermique, ne soient exposées à des échauffements compris entre 80°c et 110°C.

Selon une réalisation, le procédé est mis en oeuvre par au moins un équipement consommateur choisi au moins parmi la liste suivante: installation motrice notamment à au moins un moteur thermique, système de motorisation électrique de l'aéronef à voilure tournante, système de sécurité de l'aéronef, système d'assistance au pilotage de l'aéronef, système d'information d'urgence pour pilote d'aéronef.

Selon une réalisation, le procédé est mis en oeuvre par au moins un système de motorisation électrique d'assistance d'un pilote de l'aéronef à voilure tournante, lors d'une phase de vol en autorotation, ledit système de motorisation électrique étant alimenté par un système de stockage d'énergie électrique, ledit système de motorisation étant intégré dans une installation motrice hybride munie dudit système de motorisation électrique et d'au moins un moteur thermique, l'aéronef à voilure tournante comportant une boîte de transmission principale de puissance, ledit système de stockage d'énergie électrique à bord étant électriquement relié à ladite au moins une pile thermique, l'aéronef à voilure tournante comportant un rotor principal qui est entraîné, en vol, à une vitesse nominale de rotation par l'installation motrice hybride, de sorte que durant une étape de surveillance en vol au moins un paramètre de surveillance est mesuré afin de détecter une éventuelle panne de moteur thermique, de sorte que si une panne est détectée, on commande ledit système de motorisation électrique pour fournir une puissance auxiliaire d'entraînement en rotation au rotor principal, permettant ainsi d'assister le pilote lors d'un vol en autorotation consécutif à ladite panne.

De la sorte, le domaine de vol d'un aéronef peut être étendu et la phase de vol en autorotation sécurisée par l'utilisation du procédé selon l'invention, par exemple en permettant que les restrictions liées à un aéronef e.g. monomoteur puissent être réduites.

Un autre objet de l'invention est un aéronef à voilure tournante apte à être configuré selon le procédé évoqué plus haut.

Selon l'invention, ladite au moins une pile thermique est intégrée à l'installation électrique de l'aéronef et est logée dans au moins un cloisonnement de protection contre les rayonnements thermiques et un confinement anti-conduction thermique.

Selon l'invention, au moins un confinement anti-conduction thermique comporte une enveloppe close sur châssis, avec au moins un évent d'évacuation thermique.

Selon une réalisation, au moins une pile thermique est dédiée à une fourniture de puissance électrique de basse puissance, telle que ladite puissance utile est comprise entre 20 Watts et 300 Watts.

Selon une réalisation, au moins une pile thermique est dédiée à une fourniture de puissance électrique de forte puissance, telle que ladite puissance utile est comprise entre 50 kilowatts et 200 kilowatts.

Selon une réalisation, au moins une pile thermique est dédiée à une fourniture de puissance électrique pour une installation motrice de l'aéronef, telle que ladite puissance utile est comprise entre 5 kilowatts et 25 kilowatts, et notamment entre 10 kilowatts et 20 kilowatts.

L'invention et ses avantages apparaîtront avec plus de détails dans le cadre de la description qui suit avec des exemples de réalisation donnés à titre illustratif en référence aux figures annexées qui représentent :

- la figure 1, un aéronef selon l'invention, et,

- la figure 2, un schéma synoptique du procédé selon l'invention.

Les éléments présents dans plusieurs figures distinctes sont désignés par une seule et même référence.

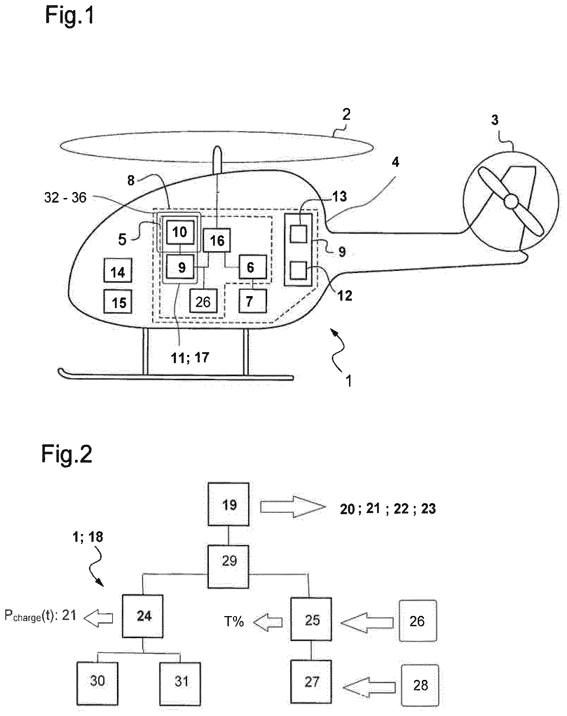

La figure 1 décrit un aéronef 1 à voilure tournante selon l'invention.

Un aéronef 1 à voilure tournante est pourvu d'au moins un rotor principal 2 pour assurer sa sustentation voire sa propulsion et généralement dans le cas d'un hélicoptère d'un rotor arrière 3 pour notamment s'opposer au couple en lacet exercé par le rotor principal 2 sur le fuselage 4 de l'aéronef 1 et pour aussi permettre de contrôler des mouvements en lacet de l'aéronef 1. Dans le cas d'aéronefs 1 hybrides à voilures tournantes, au lieu d'un rotor arrière, l'aéronef 1 selon l'invention est équipé de voilures fixes porteuses d'au moins une paire de propulseurs qui peuvent remplacer un rotor arrière anticouple.

Afin d'entraîner en rotation le rotor principal 2 et le cas échéant le rotor arrière et/ou des propulseurs, l'aéronef comporte une installation motrice 5 qui peut comporter un ou plusieurs moteurs thermiques 6, alimentés par un réservoir de carburant 7.

Il est à noter qu'on entend par « moteur thermique » les turbomoteurs et/ou encore les moteurs à pistons pouvant être utilisés dans une telle installation motrice 5. L'expression « moteur thermique » est ici à opposer à l'expression « moteur électrique » qualifiant les moteurs mus par une puissance électrique.

Sur la figure 1, l'aéronef à voilure tournante 1 intègre une installation électrique 8 et des équipements consommateurs 9 d'énergie électrique. Cette installation électrique 8 comporte selon l'invention au moins une pile thermique 10 et est apte à délivrer à la demande, une quantité prédéterminée d'énergie électrique à au moins un équipement consommateur 9.

Ces équipements consommateurs 9 sont, selon les réalisations tout ou partie d'un système de motorisation électrique 11 de l'installation motrice 5, d'un système de sécurité 12 embarqué, d'un système d'assistance 13 au pilotage de l'aéronef 1, d'un système d'information d'urgence 14 pour pilote d'aéronef, dont une interface homme machine 15, typiquement avec un affichage visuel et des émetteurs de signaux sonores.

Notamment, dans une réalisation où au moins un équipement consommateur 9 à alimenter par au moins une pile thermique 10, au moins un équipement consommateur 9 est tout ou partie d'une installation motrice 5 pourvue d'un ou plusieurs moteurs thermiques, un ou plusieurs constituants de ce ou ces moteurs thermiques formant ledit équipement consommateur 9.

Sur la figure 1, on remarque que le système de motorisation électrique 11 et le ou les moteurs thermiques 6 de l'installation motrice 5 sont mécaniquement reliés à une boîte de transmission principale de puissance (BTP) référencée en 16.

Une ou plusieurs piles thermiques 10 font donc partie d'un système de stockage d'énergie 17 électrique qui fait lui-même partie de l'installation électrique 8. L'invention propose l'utilisation de systèmes de stockage limités en nombre de cycles d'utilisation (1 à 100 cycles de charge/décharge) et en particulier à usage unique (non rechargeables). Ce type de systèmes 17 répond pleinement à la problématique peu fréquente d'apport de puissance lors de phases critiques comme la panne d'une motorisation principale de l'aéronef 1. Ces systèmes 17 sont optimisés pour assurer un fort taux de décharge : niveau de puissance très important pendant un temps court.

En bref, une pile thermique 10 est batterie non rechargeable, à usage unique, totalement inerte avant son activation. Il s'agit d'une pile par exemple au lithium qui produit une énergie à partir d'un couple électrochimique réactif.

Son fonctionnement est basé sur l'activation de « cellules », réalisées par compression de poudres, comportant chacune anode, électrolyte et cathode, complétées d'une pastille chauffante et d'un séparateur. L'électrolyte, qui constitue le milieu séparateur entre l'anode et la cathode, est en général solide. L'ensemble des cellules est inerte pendant toute la période de stockage de la pile 10.

Pour chaque pile 10, le nombre nécessaire de « cellules » est empilé afin d'obtenir la tension électrique demandée. Au moment de l'activation, les colonnes d'amorçage diffusent les calories dans les cellules, celles-ci montent en température, l'électrolyte fond et l'échange ionique peut s'opérer: la puissance de la pile 10 est ainsi disponible. Après avoir été collectée, l'énergie électrique est transmise au travers du passe-fil qui assure le passage du signal électrique vers l'extérieur.

Les piles thermiques 10 ont pour avantages connus, de former une source d'énergie de réserve, pouvant être stockée pendant plusieurs années et disponible immédiatement. Les piles thermiques 10 sont inertes pendant leur temps de stockage, parfaitement hermétiques, résistantes aux environnements sévères.

Ces piles thermiques 10 peuvent être activées en quelques dixièmes de secondes, même après des années de stockage. Les piles thermiques 10 sont adaptées aux besoins particuliers et offrent un rapport puissance spécifique (en Watts par Kg) intéressant. Les piles thermiques 10 sont classifiées comme équipements non explosifs par l'OTAN et non pyrotechniques.

Les piles thermiques 10 peuvent être classiquement couplées avec d'autres éléments au sein d'une installation électrique notamment avec des capteurs, batteries classiques, notamment pour des applications de sécurité.

En se reportant maintenant à la figure 2 notamment, un procédé de configuration 18 est décrit. Ce procédé de configuration 18 s'applique à un aéronef 1 à voilure tournante tel que celui de la figure 1.

Selon une réalisation, le procédé 18 comporte au moins une étape de définition 19 de spécifications techniques 20 de ladite au moins une pile 10 thermique et de l'installation électrique 8, en termes opérationnels, structurels et d'agencement au sein de l'aéronef 1.

Notamment, ces spécifications 20 comprennent:

- une puissance utile 21 à fournir par ladite au moins une pile 10 thermique en fonction de la quantité d'énergie électrique à délivrer par l'installation électrique 8 pour au moins ledit équipement consommateur 9, cette puissance utile 21 étant prédéterminée entre 20 Watts et 200 kilowatts,

- un laps de temps 22 de montée en puissance de ladite au moins une pile 10 thermique, jusqu'à au moins la quantité prédéterminée d'énergie électrique, ce laps de temps 22 étant compris entre 3 secondes et 30 secondes,

- un bas temps de fonctionnement 23 de fourniture utile de la quantité prédéterminée d'énergie électrique à au moins ledit équipement consommateur 9, par ladite pile 10, ce bas temps 23 étant compris entre 10 secondes et 180 secondes,

- un temps de disponibilité $t_{disponibilité}$ lors duquel ledit équipement consommateur 9 ne requiert pas d'énergie mais ladite au moins une pile thermique 10 reste chaude pour une utilisation à tout moment, ce temps de disponibilité étant compris entre 10 et 300 secondes, et

- un temps de fonctionnement de fourniture utile de la quantité prédéterminée d'énergie électrique à au moins ledit équipement consommateur 9 par ladite au moins une pile thermique 10, ce temps de fonctionnement pouvant aller jusqu'à la durée de disponibilité, en fonction de la puissance délivrée.

En fait, le temps de fonctionnement peut aller jusqu'à la durée de disponibilité puisque si peu de puissance est employée, il reste encore de l'énergie disponible qui a été produite par ladite au moins une pile thermique 10 et mise en réserve dans l'installation électrique 8, alors que ladite au moins une pile thermique 10 est froide, c'est-à-dire inopérante après emploi. Par exemple, il ne reste qu'une valeur de 30 secondes à la puissance maximale $P_{max}$. Typiquement, une pile thermique 10 est échauffée à par exemple 600°C, puis en prenant en compte l'isolation se refroidit jusqu'à perdre la capacité de son inertie thermique.

Par exemple, la puissance utile 21 est déterminée en fonction de la masse de l'aéronef 1 et de ses missions. On remarque que si l'on considère l'alimentation d'un système d'information d'urgence 14 afférant, la puissance au sein de ce système 14 n'est que de quelques watts.

Des exemples d'équipements consommateurs 9 comprennent notamment le système de motorisation électrique 11 de l'installation motrice 5. Typiquement, ces systèmes de motorisation électrique 11 nécessitent une forte puissance électrique, notamment de l'ordre de 50 à 200 kilowatts.

Selon une réalisation, au moins une pile thermique 10 est dédiée à une fourniture de puissance électrique pour l'installation motrice 5 de l'aéronef 1, telle que ladite puissance utile est e.g. comprise entre 5 kilowatts et 25 kilowatts, et notamment entre 10 kilowatts et 20 kilowatts.

Par exemple, un l'apport de puissance à un générateur de gaz peut être effectué avec une ou des piles thermiques 10. Ainsi, l'emploi d'au moins une pile thermique 10 peut être intéressant dans une installation motrice 5 et pour un générateur de gaz de turbine à combustion interne.

Dans des exemples de réalisation, ceci permet l'utilisation d'au moins une pile thermique 10, notamment lors d'un redémarrage rapide de turbine en ralenti ou super ralenti, de fourniture de puissance à l'installation motrice 5 lorsqu'un moteur de celle-ci est sollicité sur des régimes transitoires de forte puissance tels que de type OEI (One Engine Inoperative) pour les aéronefs 1 multimoteurs, ou encore en phase de montée brutale de puissance.

D'autres exemples d'équipements consommateurs 9 comprennent notamment le système de sécurité 12 embarqué, comme notamment un éclairage de secours (e.g. sous 28 Volts, 2 Ampères) qui nécessitent une basse puissance électrique, notamment de l'ordre de 50 Watts, e.g. pendant 600 secondes. Des piles thermiques selon l'invention peuvent alimenter au besoin, un horizon de secours et / ou son éclairage, qui nécessite également une basse puissance électrique, notamment de l'ordre de 50 Watts.

D'autres exemples d'équipements consommateurs 9 comprennent notamment le système d'assistance 13 nécessaires au vol et à l'atterrissage en sécurité dont une radionavigation de secours (Horizon secondaire, Taux de rotation rotor, altitude, vitesse air, etc.) qui nécessite dans des réalisations une basse puissance électrique de l'ordre de 200 à 300 Watts et une radiocommunication de secours, nécessitent que une ou des pile(s) thermique(s) 10 fourni(ssen)t selon des réalisations une basse puissance électrique de l'ordre de 100 à 200 Watts, pendant une durée courte.

Dans une réalisation selon l'invention, l'aéronef à voilure tournante 1 comporte au moins une pile thermique 10 qui est dédiée à une fourniture de puissance électrique de basse puissance, telle que ladite puissance utile 21 est comprise entre 20 Watts et 300 Watts. Une réalisation de l'invention prévoit que l'aéronef 1 comporte au moins une pile thermique 10 qui est dédiée à une fourniture de puissance électrique de forte puissance, telle que ladite puissance utile 21 est alors comprise entre 50 kilowatts et 200 kilowatts. Selon la réalisation de la figure 2, l'étape de définition 19 et donc le procédé 18 comportent au moins une routine de maximisation 24 de la quantité de puissance utile fournie $P_{charge}(t)$ en fonction du temps t, c'est-à-dire la puissance 21, lors de l'activation de ladite au moins une pile 10. Cette routine 24 commande un fonctionnement électrique à adaptation d'impédance dudit au moins un équipement consommateur 9 aussi appelé charge.

On comprend que la routine de maximisation 24 est élaborée lors d'une configuration de l'aéronef 1 et est exécutée lors du fonctionnement de cet aéronef 1, quand ladite au moins une pile 10 est employée.

Cette routine de maximisation 24 vise à fournir la plus grande énergie possible le plus vite possible e.g. au système de motorisation électrique 11 et donc à l'aéronef 1 pour limiter la perte de puissance due à la panne moteur, et ainsi améliorer la pilotabilité et la sécurité du vol.

Dès lors, la routine 24 prévoit que ladite pile 10 équivaut, selon un modèle de conversion de Thévenin, à un circuit électrique linéaire en boucle, auquel s'applique en série la résistance $R_{pile}$ de la pile thermique 10 et la résistance R$_{charge}$ de l'équipement, une force électromotrice FEM$_{pile}$ de la pile 10, une intensité I$_{pile}$(t) du courant électrique et une tension électrique de charge U$_{charge}$(t) de l'équipement 9.

Par suite, cette routine 24 détermine une valeur du de la tension de charge U$_{charge}$(t) qui annule la dérivée, soit l'équation :

$$\frac{dP_{charge}(t)}{dI_{charge}(t)} = FEM_{pile} - 2 * R_{pile}(t) * I_{charge}(t) = 0$$

De la sorte, la tension de charge U$_{charge}$(t) est atteinte lorsque la résistance R$_{charge}$ de l'équipement 9 est égale à la résistance R$_{pile}$ de la pile 10 formant la source dudit circuit.

Selon cet exemple de routine 24, la maximisation adapte ladite tension de charge U$_{charge}$(t) pour obtenir :

$$U_{charge}(t) = \frac{FEM_{pile}}{2}.$$

Selon la réalisation de la figure 2, l'aéronef 1 comporte un agencement de contrôle électrique 28. Selon une réalisation, cet agencement 28 comporte un dispositif de déclenchement de ladite au moins une pile 10.

Par exemple, le dispositif de déclenchement comprend au moins un inflammateur mécanique qui est sensible aux accélérations de l'aéronef 1 supérieures à une valeur de seuil de déclenchement. Lorsque ce seuil de déclenchement est atteint, le dispositif de déclenchement provoque automatiquement l'activation de ladite au moins une pile 10.

Dans une autre réalisation, le dispositif de déclenchement comprend au moins un gyroscope par exemple de type MEMS, sensible aux accélérations de l'aéronef 1 supérieures à une valeur de seuil de déclenchement.

Encore une autre réalisation prévoit que le dispositif de déclenchement comprend au moins un déclencheur de perte de tension sensible à une tension électrique inférieure à une valeur de tension seuil dans l'installation électrique. Lorsque cette valeur de tension seuil est atteinte, le dispositif de déclenchement provoque automatiquement l'activation de ladite au moins une pile 10.

Selon la réalisation de la figure 2, le procédé 18 comprend une règle d'évaluation 25 de la quantité d'énergie électrique disponible après activation.

On comprend que la règle d'évaluation 25 est élaborée lors d'une configuration de l'aéronef 1 et est exécutée lors du fonctionnement de cet aéronef 1, quand ladite au moins une pile 10 est employée.

Il s'agit de la quantité d'énergie électrique disponible après activation auprès de ladite au moins une pile 10 du système 17.

Lors du fonctionnement de ladite au moins une pile 10 thermique, les paramètres de vol en temps réel de l'aéronef 1 suivants sont mesurés par exemple par un dispositif de mesure 26:

- l'énergie initiale dans la pile 10 E$_{initiale}$,

- la puissance maximale demandée P$_{max}$,

- le temps disponible T$_{disponible.max}$ à cette puissance maximale demandée P$_{max}$,

- le temps de fonctionnement T$_{fonctionnement.max}$, limité par une valeur par exemple d'au moins un capteur thermique du dispositif 26, qui est obtenu lors de l'étape de définition 19 de spécifications techniques, et,

- à partir :

   ∘ d'un instant d'activation mesuré t$_{activation}$ du début de l'activation,

   ∘ d'un instant courant t$_{courant}$ mesuré, et,

   ∘ d'une puissance courante délivrée P$_{delivree}$(t) mesuré à l'instant courant t$_{courant}$, telle que :

$$P_{delivree}(t) = U_{charge}(t_{courant}) * I_{charge}(t_{courant});$$

   et

- la règle d'évaluation 26 fournit une valeur en pourcentage T% de l'énergie, calculée comme suit. Ladite règle d'évaluation de la quantité d'énergie électrique disponible lors du fonctionnement de ladite au moins une pile thermique, fournit une valeur en pourcentage T% d'énergie à l'instant courant $t_{courant}$ à partir de l'énergie restante $E_{restante}$ dans la pile. Cette énergie restante $E_{restante}$ est obtenue par dérivation de l'énergie initiale $E_{initiale}$ dans la pile, dérivée de l'instant d'activation mesuré $t_{activation}$ à l'instant courant $t_{courant}$ pour une énergie délivrée $P_{délivrée}(t)$ à cet instant courant $t_{courant}$, où $P_{delivree}(t) = U_{charge}(t_{courant}) * I_{charge}(t_{courant})$ et selon la formule suivante :

$$E_{restante} = E_{initiale} - \int_{t_{activation}}^{t} P_{délivrée}(t)dt.$$

Puis, à partir de l'énergie $E_{restante}$, ladite règle d'évaluation détermine le temps « $T_{restant\ à\ puissance\ P}$ » en fonction de la puissance P qui est la puissance mesuré à l'instant courant $t_{courant}$ et d'un temps « $\overline{T_{disponible.max}}$ » à puissance maximale qui est propre à ladite au moins une pile thermique 10 telle que dimensionnée. Dès lors, ladite règle d'évaluation 25 calcule la valeur T% de l'énergie, à partir de la formule suivante :

$$T_{restant\ à\ puissance\ P} = \frac{E_{restante}}{P}$$

de sorte que la valeur T% de l'énergie est :

$$T\% = \frac{T_{restant\ à\ puissance\ P}}{T_{disponible.max}} \times 100.$$

Selon les réalisations, la puissance P est par exemple la puissance courante délivrée $P_{delivree}(t)$ ou la puissance maximale demandée $P_{max}$.

On comprend qu'une telle valeur T% est utile au pilotage de l'aéronef 1, et peut typiquement être fournie e.g. par affichage sur l'interface homme-machine 15, à la demande et/ou en situation détecté d'urgence.

On comprend que le calcul de T% peut être calculé pour toute valeur de puissance P, le temps restant à pleine puissance étant limité par la durée de disponibilité. Dans des exemples, une valeur intéressante de T% est obtenue lorsque la puissance considérée est la $P_{max}$.

Dans des réalisations de l'aéronef 1, au moins certaines des données et valeurs produites par le procédé selon l'invention, sont mises à la connaissance du ou des pilotes de l'aéronef, typiquement via son interface Homme Machine (HMI) 15. Par exemple, le valeur T% est indiquée de manière visuelle par l'interface 15, e.g. sur un cadran, des voyants à allumage proportionnel à une valeur, au moins un afficheur à couleurs multiples, respectivement dédiées à une valeur.

Selon la réalisation de la figure 2, le procédé 18 comporte également une loi de contrôle de réduction d'impédance 27. La technologie de ladite au moins une pile 10 est telle qu'à l'activation, la résistance interne de ladite au moins une pile 10 diminue progressivement. En effet, les sels de l'électrolyte deviennent peu à peu liquides en chauffant et permettent le passage d'un courant électrique de plus en plus important.

Selon une réalisation, la loi de contrôle de réduction d'impédance 27 est mise en exécution par exemple par un agencement de contrôle électrique 28 (figure 2), intégré à l'aéronef 1.

On comprend que la loi de contrôle de réduction 27 est élaborée lors d'une configuration de l'aéronef 1 et est exécutée lors du fonctionnement de cet aéronef 1, quand ladite au moins une pile 10 est employée.

Suivant cette loi de contrôle de réduction 27, l'agencement de contrôle électrique 28 scrute la résistance interne, pendant la durée de diminution de résistance qui est comprise entre 100ms (millisecondes) et 3 secondes. Cette loi 27 permet de vérifier que le courant électrique d'appel d'une électronique de puissance du convertisseur de l'installation électrique 8 est convenable. Dès lors, cette installation électrique 8 ne comporte pas de résistance de pré-charge à fonction de limitation de ce courant d'appel.

Selon la réalisation de la figure 2, le procédé 18 comporte une procédure de surveillance thermique 30 de ladite au moins une pile 10 et une procédure de protection thermique 31 de maintien de ladite pile 10 dans une plage de températures prédéterminée. Cette plage est prédéterminée afin de garantir une fourniture optimale d'énergie électrique, tout en évitant que des structures de l'aéronef 1 connexes à la pile 10 ne soient exposées à des échauffements inacceptables, voire délétères.

On comprend que ces procédures 30 et 31 sont élaborées lors d'une configuration de l'aéronef 1 et sont exécutées lors du fonctionnement de cet aéronef 1, quand ladite au moins une pile 10 est employée.

Cette plage de températures prédéterminée est comprise entre 80°C et 110°C, selon l'exemple de la figure 2.

On remarque que c'est la technologie de la ou des piles thermiques 10 qui impose le principal apport thermique. Le dimensionnement permet de chauffer le coeur de pile à une température allant jusqu'à 600°C.

Cette chauffe est rapide. Ensuite, la pile se refroidit par elle-même (conduction / rayonnement). En dessous de 450°C, la pile ne fonctionne plus car les sels sont redevenus solides. L'isolation de la pile permet de maintenir la température à coeur le plus longtemps possible, et également de limiter la température de la surface de la pile. On peut également mettre la pile dans un container supplémentaire permettant d'isoler la pile de son environnement et de guider les éventuels gaz émis lors de défaillance à l'extérieur de l'aéronef, tel que décrit ci-dessous.

D'ailleurs, selon l'exemple de la figure 1, ladite au moins une pile 10 est intégrée à l'installation électrique 8 avec au moins un cloisonnement de protection 32 contre les rayonnements thermiques produits par ladite au moins une pile thermique 10 et/ou un confinement anti-conduction thermique 33. Selon cette réalisation, un confinement anti-conduction 33 comporte une enveloppe 34 close agencée sur châssis isolant 35, avec au moins un évent d'évacuation thermique 36.

Typiquement, le cloisonnement 32 permet de limiter l'impact de la température de chaque pile 10 sur les autres équipements de l'installation 8.

Par ailleurs, dans un exemple, l'évent 36 de l'enveloppe 34 close répond à deux fonctions notamment:

- permettre une mise à l'air extérieur de la pile 10 pour limiter les températures vues par un inflammateur d'actionnement de chaque pile 10, typiquement de 80°C à 110°C, températures auxquelles l'inflammateur se dégrade ; et
- permettre une évacuation des gaz issus d'un mauvais fonctionnement de chaque pile 10 dans l'enveloppe 34.

Selon une réalisation, le procédé 18 est mis en oeuvre pour au moins un équipement consommateur 9 choisi parmi au moins la liste suivante: système de motorisation électrique 11 de l'aéronef 1 à voilure tournante, système de sécurité de l'aéronef 1 (par exemple : alimentation secours des commandes de vol électrique), système d'assistance au pilotage de l'aéronef 1, au système d'information d'urgence pour pilote d'aéronef 1 (par exemple : éclairage de secours, horizon de secours et équipements de radiocommunication et radionavigation nécessaires à la survie en cas de perte de génération électrique).

Selon la réalisation de la figure 2, le procédé 18 est mis en oeuvre par au moins un système de motorisation électrique d'assistance d'un pilote de l'aéronef 1 à voilure tournante, lors d'une phase de vol en autorotation. Par exemple, l'enseignement du document FR2994687 évoqué plus haut, est combiné avec l'invention, par l'intégration d'une ou plusieurs pile(s) 10 à l'installation électrique 8.

Par suite, le système de motorisation électrique 11 est alimenté par un système de stockage d'énergie électrique 17. Le système de motorisation électrique 11 est alors intégré dans l'installation motrice 5 de type hybride avec au moins un moteur thermique 6.

Sur la figure 2, le procédé 18 comporte une étape de surveillance en vol 29 prévoit qu'est mesuré au moins un paramètre de surveillance, par exemple via le dispositif de mesure 26, afin de détecter une éventuelle panne de moteur thermique 6.

Lorsqu'une panne est détectée, on commande soit manuellement soit automatiquement, le système de motorisation électrique 11 pour fournir une puissance auxiliaire d'entraînement en rotation au rotor principal 2. Cette puissance auxiliaire permet d'assister le pilote lors d'un vol en autorotation consécutif à la panne.

De la sorte, le domaine de vol d'un aéronef 1 peut être étendu et la phase de vol en autorotation sécurisée par l'utilisation du procédé 18 selon l'invention, par exemple en permettant que les restrictions liées à un aéronef monomoteur 1 puissent être réduites.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent sans sortir du cadre de la présente invention.

Liste des références numériques

1    aéronef 1 à voilure tournante
2    rotor principal 2
3    rotor arrière 3 ou propulseurs
4    fuselage 4
5    installation motrice 5

6       moteur thermique 6
7       réservoir de carburant 7
8       installation électrique 8
9       équipements consommateurs 9
10      pile thermique 10
11      système de motorisation électrique 11
12      système de sécurité 12
13      système d'assistance 13 au pilotage
14      système d'information d'urgence 14 pour pilote
15      interface homme machine 15
16      boîte de transmission primaire 16
17      système de stockage d'énergie 17
18      procédé de configuration 18
19      étape de définition 19
20      spécifications techniques 20
21      puissance utile 21
22      laps de temps 22
23      bas temps de fonctionnement 23
24      routine de maximisation 24
25      règle d'évaluation 25
26      dispositif de mesure 26
27      loi de réduction d'impédance 27
28      agencement de contrôle électrique 28
29      étape de surveillance 29
30      procédure de surveillance thermique 30
31      procédure de protection thermique 31
32      cloisonnement de protection 32
33      confinement anti-conduction thermique 33
34      enveloppe close 34
35      Châssis isolant
36      Event évacuation thermique

**Revendications**

**1.** Procédé (18) de configuration d'un aéronef à voilure tournante, cet aéronef à voilure tournante intégrant une installation électrique (8) et des équipements consommateurs d'énergie électrique, cette installation électrique (8) comportant au moins une pile thermique (10) et étant apte à délivrer à la demande, une quantité prédéterminée d'énergie électrique à au moins un équipement consommateur (9),

le procédé (18) comportant au moins une étape d'alimentation de l'installation électrique (8) et des équipements consommateurs (5, 9, 11, 12, 13, 14) selon une définition (19) de spécifications techniques (20) de ladite au moins une pile (10) et de l'installation électrique (8) en termes opérationnels, structurels et d'agencement au sein de l'aéronef (1), l'étape d'alimentation selon ces spécification techniques (20) comprenant:

- une puissance utile (21) à fournir par ladite au moins une pile thermique (10) en fonction de la quantité d'énergie électrique à délivrer par l'installation électrique pour au moins ledit équipement consommateur,
- un laps de temps (22) de montée en puissance de ladite au moins une pile thermique, jusqu'à au moins la quantité prédéterminée d'énergie électrique,
- un bas temps de fonctionnement (23) de fourniture utile de la quantité prédéterminée d'énergie électrique à au moins ledit équipement consommateur, par ladite au moins une pile thermique (10),
- un temps de disponibilité $t_{disponibilité}$ lors duquel ledit équipement consommateur (9) ne requiert pas d'énergie mais ladite au moins une pile thermique (10) reste chaude pour une utilisation à tout moment,

**caractérisé en ce que** la puissance utile (21) est prédéterminée entre 20 Watts et 200 kilowatts, le laps de temps (22) de montée en puissance est compris entre 3 secondes et 30 secondes, le bas temps de fonctionnement (23) de fourniture utile est compris entre 10 secondes et 180 secondes, et le temps de disponibilité $t_{disponibilité}$ est compris entre 10 et 300 secondes ; et **en ce que** l'étape d'alimentation selon la définition (19) de spécifications techniques (20) comportant au moins une routine de maximisation (24) de la quantité de puissance utile fournie $P_{charge}(t)$ en fonction du temps « t » lors de l'activation de ladite au moins une pile thermique (10), cette routine de maximisation commandant un fonctionnement électrique à adaptation d'impédance dudit au moins un équipement consommateur (9) ou charge, la routine de maximisation (24) prévoyant que ladite au moins une pile thermique (10) équivaut, selon un modèle de conversion de Thévenin, à un circuit électrique linéaire en boucle, auquel s'applique en série la résistance $R_{pile}$ de la pile et la résistance $R_{charge}$ de l'équipement (9), une force électromotrice $FEM_{pile}$ de la pile, une intensité $I_{pile}(t)$ du courant électrique et une tension électrique de charge $U_{charge}(t)$ de l'équipement (9), de sorte que cette routine de maximisation (24) détermine une valeur de la tension de charge $U_{charge}(t)$ qui annule la dérivée:

$$\frac{dP_{charge}(t)}{dI_{charge}(t)} = FEM_{pile} - 2 * R_{pile}(t) * I_{charge}(t) = 0$$

la tension de charge $U_{charge}(t)$ étant atteinte lorsque la résistance $R_{charge}$ de l'équipement égale la résistance $R_{pile}$ de la pile formant source, de façon que la routine de maximisation (24) adapte ladite tension de charge $U_{charge}(t)$ pour obtenir :

$$U_{charge}(t) = \frac{FEM_{pile}}{2}.$$

2. Procédé (18) selon la revendication 1,
**caractérisé en ce que** le procédé comprend une règle d'évaluation (25) après activation de la quantité d'énergie électrique disponible auprès de ladite au moins une pile thermique (10) lors de son fonctionnement, ladite règle d'évaluation (25) fournit une valeur en pourcentage T% d'énergie à l'instant courant $t_{courant}$ à partir de l'énergie restante $E_{restante}$ dans ladite pile (10), cette énergie restante $E_{restante}$ étant obtenue par dérivation de l'énergie initiale $E_{initiale}$ dans ladite pile (10), dérivée de l'instant d'activation mesuré $t_{activation}$ à l'instant courant $t_{courant}$ pour une énergie délivrée $P_{délivrée}(t)$ à cet instant courant $t_{courant}$, OÙ $P_{delivree}(t) = U_{charge}(t_{courant}) * I_{charge}(t_{courant})$ et selon la formule suivante:

$$E_{restante} = E_{initiale} - \int_{t_{activation}}^{t} P_{délivrée}(t)dt$$

puis, à partir de l'énergie $E_{restante}$, ladite règle d'évaluation détermine le temps « $T_{restant\ à\ puissance\ P}$ » en fonction de la puissance P qui est la puissance mesurée à l'instant courant $t_{courant}$ et d'un temps « $T_{disponible.max}$ » à puissance maximale qui est propre à dans ladite pile (10) telle que dimensionnée, ladite règle d'évaluation (25) calcule la valeur T% de l'énergie, à partir de la formule suivante :

$$T_{restant\ à\ puissance\ P} = \frac{E_{restante}}{P}$$

de sorte que la valeur T% de l'énergie est :

$$T\% = \frac{T_{restant\ à\ puissance\ P}}{T_{disponible.max}} \times 100.$$

3. Procédé (18) selon l'une des revendications 1 ou 2, **caractérisé en ce que** le procédé (18) comporte une loi de contrôle de réduction d'impédance (27), telle qu'à l'activation de ladite au moins une pile (10), la résistance interne de cette pile thermique qui diminue progressivement est scrutée, pendant la durée de diminution de résistance qui est comprise entre 100ms (millisecondes) et 3 secondes, la loi de contrôle de réduction d'impédance (27) vérifiant que le courant d'appel d'une électronique de puissance du convertisseur de l'installation électrique est convenable, de sorte que l'installation électrique (8) ne comporte pas de résistance de pré-charge à fonction de limitation de ce courant d'appel.

4. Procédé (18) selon l'une des revendications 1 à 3,
**caractérisé en ce que** le procédé (18) comporte une surveillance thermique (30) de ladite au moins une pile thermique (10) et une procédure de protection thermique (31) de maintien de ladite au moins une pile thermique (10) dans une plage de températures garantissant une fourniture optimale d'énergie tout en évitant que les structures de l'aéronef (1), connexes à ladite au moins une pile thermique (10), ne soient exposées à des échauffements compris entre 80°c et 110°C.

5. Procédé (18) selon l'une des revendications 1 à 4,
**caractérisé en ce que** le procédé est mis en oeuvre pour au moins un équipement consommateur (9) parmi au moins la liste suivante: installation motrice (5), système de motorisation électrique (11) de l'aéronef (1), système de sécurité (12) de l'aéronef, système d'assistance (13) au pilotage de l'aéronef, système d'information d'urgence (14) pour pilote d'aéronef.

6. Procédé (18) selon la revendication 5,
**caractérisé en ce que** le procédé est mis en oeuvre par au moins un système de motorisation électrique d'assistance d'un pilote de l'aéronef (1) à voilure tournante, lors d'une phase de vol en autorotation, ledit système de motorisation électrique (11) étant alimenté par un système de stockage d'énergie électrique (17), ledit système de motorisation électrique d'assistance étant intégré dans une installation motrice hybride munie dudit système de motorisation électrique (11) et d'au moins un moteur thermique (6), l'aéronef (1) comportant une boîte de transmission principale (16) de puissance, ledit système de stockage d'énergie électrique (17) à bord étant électriquement relié à ladite au moins une pile thermique (10), l'aéronef à voilure tournante (1) comportant un rotor principal (2) qui est entraîné, en vol, à une vitesse nominale de rotation par l'installation motrice hybride, de sorte que durant une étape (29) de surveillance en vol au moins un paramètre de surveillance est mesuré afin de détecter une éventuelle panne de moteur thermique ; de sorte que si une panne est détectée, on commande ledit système de motorisation électrique (11) pour fournir une puissance auxiliaire d'entraînement en rotation au rotor principal, permettant ainsi d'assister le pilote lors d'un vol en autorotation consécutif à ladite panne.

7. Aéronef à voilure tournante configuré selon le procédé (18) de l'une des revendications 1 à 6,
**caractérisé en ce que** ladite au moins une pile thermique (10) intégrée à l'installation électrique (8) est logée dans au moins un cloisonnement de protection (32) contre les rayonnements thermiques et un confinement anti-conduction thermique (33), et qu'au moins un confinement anti-conduction thermique (33) comporte une enveloppe close (34) sur châssis (35), avec au moins un évent (36) d'évacuation thermique.

8. Aéronef à voilure tournante selon la revendication 7,
**caractérisé en ce qu'**au moins une pile thermique (10) est dédiée à une fourniture de puissance électrique de basse puissance, telle que ladite puissance utile (21) est comprise entre 20 Watts et 300 Watts.

9. Aéronef à voilure tournante selon la revendication 7,
**caractérisé en ce qu'**au moins une pile thermique (10) est dédiée à une fourniture de puissance électrique de forte puissance, telle que ladite puissance utile (21) est comprise entre 50 kilowatts et 200 kilowatts.

10. Aéronef à voilure tournante selon la revendication 7,
**caractérisé en ce qu'**au moins une pile thermique (10) est dédiée à une fourniture de puissance électrique pour une installation motrice (5) de l'aéronef (1), telle que ladite puissance utile (21) est comprise entre 5 kilowatts et 25 kilowatts, et par exemple entre 10 kilowatts et 20 kilowatts.

**Patentansprüche**

1. Verfahren (18) zur Konfigurierung eines Drehflügelflugzeugs, wobei das Drehflügelflugzeug eine elektrische Anlage (8) und elektrische Energie verbrauchende Ausrüstungen aufweist, wobei die elektrische Anlage (8) mindestens eine Thermalbatterie (10) aufweist und auf Anforderung eine vorbestimmte Menge elektrischer Energie an mindestens eine Verbraucherausrüstung (8) liefern kann,
wobei das Verfahren (18) mindestens einen Schritt der Speisung der elektrischen Anlage (8) und der Verbraucherausrüstungen (5, 9, 11, 12, 13, 14) gemäß einer Definition (19) technischer Spezifikationen (20) der mindestens einen Batterie (10) und der elektrischen Anlage (8) in operativer, struktureller Hinsicht und bezüglich der Anordnung im Flugzeug (1) aufweist, wobei der Schritt der Speisung gemäß dieser technischen Spezifikation (20) aufweist:

- eine Abgabeleistung (21), die von der mindestens einen Thermalbatterie (10) zu liefern ist, in Abhängigkeit von der von der elektrischen Anlage zu liefernden elektrischen Energiemenge für mindestens die Verbraucherausrüstung,
- einen Leistungssteigerungszeitraum (22) der mindestens einen Thermalbatterie bis mindestens auf die vorbestimmte Menge elektrischer Energie,
- eine kurze Betriebszeit (23) der Abgabe der vorbestimmten Menge elektrischer Energie an mindestens die Verbraucherausrüstung durch die mindestens eine Thermalbatterie (10),
- eine Zeit der Verfügbarkeit $t_{Verfügbarkeit}$, während der die Verbraucherausrüstung (9) keine Energie erfordert, jedoch die mindestens eines Thermalbatterie (10) für eine jederzeitige Verwendung warm bleibt,

**dadurch gekennzeichnet, dass** die Abgabeleistung (21) vorbestimmt ist zwischen 20 Watt und 200 Kilowatt, der Leistungssteigerungszeitraum (22) zwischen 3 Sekunden und 30 Sekunden liegt, die kurze Betriebszeit (23) der Abgabe zwischen 10 Sekunden und 180 Sekunden liegt, und die Verfügbarkeitszeit $t_{Verfügbarkeit}$ zwischen 10 und 300 Sekunden liegt, und dadurch, dass der Schritt der Speisung gemäß der Definition (19) technischer Spezifikationen (20) mindestens eine Maximierungsroutine (24) der Abgabeleistungsmenge $P_{Last}(t)$ in Abhängigkeit von der Zeit "t" während der Aktivierung der mindestens einen Thermalbatterie (10), wobei die Maximierungsroutine einen elektrischen Betrieb mit Anpassung der Impedanz der mindestens einen Verbraucherausrüstung (9) oder Last steuert, wobei die Maximierungsroutine (24) vorsieht, dass die mindestens eine Thermalbatterie (10) nach einem Umwandlungsmodell von Thévenin einem linearen elektrischen Regelkreis gleichkommt, bei dem nacheinander der Widerstand $R_{Batterie}$ der Batterie und der Widerstand $R_{Last}$ der Ausrüstung (9), eine elektromotorische Kraft $FEM_{Batterie}$ der Batterie, eine elektrische Stromstärke $I_{Batterie}(t)$ und eine Versorgungsspannung $U_{Versorgung}(t)$ der Ausrüstung (9) derart Anwendung finden, dass diese Maximierungsroutine (24) einen Wert der Versorgungsspannung $U_{Versorgung}(t)$ bestimmt, der die Ableitung annulliert:

$$\frac{dP_{Last}(t)}{dI_{Last}(t)} = FEM_{Batterie} - 2 * R_{Batterie}(t) * I_{Batterie}(t) = 0 \, ,$$

wobei die Lastspannung $U_{Last}(t)$ erreicht wird, wenn der Widerstand $R_{Last}$ der Ausrüstung gleich dem Widerstand $R_{Batterie}$ der Batterie ist, die eine Energiequelle bildet, derart, dass die Maximierungsroutine (24) die Lastspannung $U_{Last}(t)$ anpasst, um zu erhalten:

$$U_{Last}(t) = \frac{FEM_{Batterie}}{2} \, .$$

2. Verfahren (18) nach Anspruch 1,
**dadurch gekennzeichnet, dass** das Verfahren eine Regel (25) zur Bewertung nach der Aktivierung der von der mindestens einen Thermalbatterie (10) verfügbaren Menge elektrischer Energie während ihres Betriebs aufweist, wobei die Bewertungsregel (25) einen Prozentwert T% der Energie zum aktuellen Zeitpunkt $t_{aktuell}$ ausgehend von der in der Batterie (10) verbleibenden Energie $E_{verbleibend}$ liefert, wobei diese verbleibende Energie $E_{verbleibend}$ erhalten wird durch Ableitung der ursprünglichen Energie $E_{ursprünglich}$ in der Batterie (10), die von dem Zeitpunkt der gemessenen Aktivierung $t_{Aktivierung}$ bis zum aktuellen Zeitpunkt $t_{aktuell}$ abgeleitet wird für eine zu diesem aktuellen Zeitpunkt $t_{aktuell}$ gelieferte Energie $P_{geliefert}(t)$, wobei $P_{geliefert}(t) = U_{Last}(t_{aktuell}) * I_{Last}(t_{aktuell})$ gilt und gemäß der folgenden Formel:

$$E_{verbleibend} = E_{ursprünglich} - \int_{t_{Aktivierung}}^{t} P_{geliefert}(t)dt \, ,$$

wobei dann die Bewertungsregel ausgehend von der verbleibenden Energie $E_{verbleibend}$ die Zeit "$T_{verbleibend\ bei\ Leistung\ P}$" in Abhängigkeit von der Leistung P bestimmt, die die zum aktuellen Zeitpunkt $t_{aktuell}$ gemessene Leistung ist, und von einer Zeit "$T_{verfügbar.max}$" mit maximaler Leistung, die der Batterie (10), wie sie dimensioniert ist, eigen ist, wobei die Bewertungsregel (25) den Prozentwert T% der Energie ausgehend von der folgenden Formel berechnet:

$$T_{verbleibend\ bei\ Leistung\ P} = \frac{E_{verbleibend}}{P} \, ,$$

derart, dass der Prozentwert T% der Energie der folgende ist:

$$T\% = \frac{T_{verbleibend\ bei\ Leistung\ P}}{T_{verf\ddot{u}gbar.max}} \ x \ 100 \ .$$

3. Verfahren (18) nach einem der Ansprüche 1 oder 2,
   **dadurch gekennzeichnet, dass** das Verfahren (18) eine Regel zur Steuerung der Reduzierung der Impedanz (27) aufweist, derart, dass bei der Aktivierung der mindestens einen Batterie (10) der Innenwiderstand dieser Thermalbatterie, der fortlaufend abnimmt, abgerufen wird, während der Dauer der Abnahme des Widerstands, die zwischen 100 ms (Millisekunden) und 3 Sekunden liegt, wobei die Regel zur Steuerung der Abnahme der Impedanz (27) überprüft, ob der Einschaltstrom einer Leistungselektronik des Wandlers der elektrischen Anlage angemessen ist, derart, dass die elektrische Anlage (8) keinen Vorlast-Widerstand zur Begrenzung des Einschaltstroms aufweist.

4. Verfahren (18) nach einem der Ansprüche 1 bis 3,
   **dadurch gekennzeichnet, dass** das Verfahren (18) eine thermische Überwachung (30) für die mindestens eine Thermalbatterie (10) und ein thermisches Schutzverfahren (31) umfasst zum Halten der mindestens einen Thermalbatterie (10) in einem Temperaturbereich, der eine optimale Energielieferung garantiert, wobei vermieden wird, dass die Strukturen des Flugzeugs (1), die mit der mindestens einen Thermalbatterie (10) verbunden sind, Aufheizungen ausgesetzt sind, die zwischen 80 °C und 110 °C liegen.

5. Verfahren (18) nach einem der Ansprüche 1 bis 4,
   **dadurch gekennzeichnet, dass** das Verfahren für mindestens eine Verbraucherausrüstung (9) angewendet wird aus mindestens der folgenden Listen: Antriebsaggregat (5), System der elektrischen Motorisierung (11) des Flugzeugs (1), Sicherheitssystem (12) des Flugzeugs, Flugassistenzsystem (13) des Flugzeugs, Notfallinformationssystem (14) für den Piloten des Flugzeugs.

6. Verfahren (18) nach Anspruch 5,
   **dadurch gekennzeichnet, dass** das Verfahren ausgeführt wird durch mindestens ein elektrisches Motorisierungssystem zur Unterstützung eines Piloten des Drehflügelflugzeugs (1) während einer Autorotationsflugphase, wobei das elektrische Motorisierungssystem (11) gespeist wird von einem System zur Speicherung elektrischer Energie (17), wobei das elektrische Unterstützungs-Motorisierungssystem in ein Hybridantriebsaggregat integriert ist, welches mit dem elektrischen Motorisierungssystem (11) und mindestens einem thermischen Motor (6) ausgerüstet ist, wobei das Flugzeug (1) ein Hauptleistungsgetriebe (16) aufweist, wobei das Bordsystem zur Speicherung elektrischer Energie (17) elektrisch mit der mindestens einen Thermalbatterie (10) verbunden ist, wobei das Drehflügelflugzeug (1) einen Hauptrotor (2) aufweist, der während des Flugs von dem Hybridantriebsaggregat mit einer Nominaldrehzahl angetrieben wird, derart, dass während eines Überwachungsschritts (29) während des Flugs mindestens ein Überwachungsparameter gemessen wird, um eine eventuelle Panne des thermischen Motors zu erfassen, derart, dass, wenn eine Panne erfasst ist, das elektrische Motorisierungssystem (11) gesteuert wird, um eine Hilfsdrehantriebsleistung an den Hauptrotor zu liefern, um somit den Piloten während eines Autorotationsflugs infolge der Panne unterstützen zu können.

7. Drehflügelflugzeug, welches gemäß dem Verfahren (18) nach einem der Ansprüche 1 bis 6 konfiguriert ist,
   **dadurch gekennzeichnet, dass** mindestens eine in die elektrische Anlage (8) integrierte Thermalbatterie (10) in mindestens einem abgetrennten Raum (32) zum Schutz gegen thermische Strahlung und in einer nicht thermisch leitenden Ummantelung (33) angeordnet ist, und mindestens eine nicht thermisch leitende Ummantelung (33) eine geschlossene Hülle (34) auf einem Rahmen (35) aufweist mit mindestens einer Lüftungsöffnung (36) zur thermischen Entlüftung.

8. Drehflügelflugzeug nach Anspruch 7,
   **dadurch gekennzeichnet, dass** mindestens eine Thermalbatterie (10) für eine Lieferung niedriger elektrischer Leistung bestimmt ist, wobei die Abgabeleistung (21) zwischen 20 Watt und 300 Watt liegt.

9. Drehflügelflugzeug nach Anspruch 7,
   **dadurch gekennzeichnet, dass** die mindestens eine Thermalbatterie (10) für eine Lieferung einer hohen elektrischen Leistung bestimmt ist, wobei die Abgabeleistung (21) zwischen 50 Kilowatt und 200 Kilowatt liegt.

10. Drehflügelflugzeug nach Anspruch 7,

**dadurch gekennzeichnet, dass** mindestens eine Thermalbatterie (10) für die Lieferung elektrischer Leistung für ein Antriebsaggregat (5) des Flugzeugs (1) bestimmt ist, wobei die Abgabeleistung (21) zwischen 5 Kilowatt und 25 Kilowatt, zum Beispiel zwischen 10 Kilowatt und 20 Kilowatt, liegt.

**Claims**

1. Method (18) of configuring a rotary wing aircraft, the rotary wing aircraft incorporating an electrical installation (8) and pieces of equipment consuming electrical energy, the electrical installation (8) comprising at least one thermal battery (10) and being suitable for delivering on demand, a predetermined quantity of electrical energy to at least one piece of consuming equipment (9),
the method (18) comprising at least a step of supplying the electrical installation (8) and pieces of consuming equipment (5, 9, 11, 12, 13, 14) according to a definition (19) of technical specifications (20) of said at least one battery (10) and the electrical installation (8) in operational terms, in structural terms and in terms of arrangement within the aircraft (1), the step of supplying according to the technical specifications (20) comprising:

- a usable power (21) to be provided by said at least one thermal battery (10) as a function of the quantity of electrical energy to be delivered by the electrical installation for at least said consuming equipment,
- a power rise time lapse (22) of said at least one thermal battery, for rising at least to the predetermined quantity of electrical energy,
- a low operating time (23) for useful provision of the predetermined quantity of electrical energy to at least said consuming equipment, by said at least one thermal battery (10),
- an availability time $t_{availability}$ during which said consuming equipment (9) does not require energy but said at least one thermal battery (10) remains hot for use at any moment,

**characterised in that** the usable power (21) is predetermined between 20 watts and 200 kilowatts, the power rise time lapse (22) is comprised between 3 seconds and 30 seconds, the low operating time (23) for useful provision is comprised between 10 seconds and 180 seconds, and the availability time $t_{availability}$ is comprised between 10 and 300 seconds; and **in that** the step of supplying according to the definition (19) of technical specifications (20) comprising at least one maximization routine (24) for maximizing the quantity of usable power provided $P_{load}(t)$ as a function of time "t" upon the activation of said at least one thermal battery (10), the maximization routine controlling an impedance-matching electrical operation of said at least one piece of consuming equipment (9) or load, the maximization routine (24) assuming that said at least one thermal battery (10) is equivalent, according to a Thévenin conversion model, to a looped linear electric circuit, to which applies in series the resistance $R_{battery}$ of the battery and the resistance $R_{load}$ of the equipment (9), an electromotive force $EMF_{battery}$ of the battery, an intensity $I_{battery}(t)$ of the electric current and a load electric voltage $U_{load}(t)$ of the equipment (9), such that the maximization routine (24) determines a load voltage value $U_{load}(t)$ which cancels the derivative:

$$\frac{dP_{load}(t)}{dI_{load}(t)} = EMF_{battery-2} * R_{battery}(t) * I_{load}(t) = 0$$

the load voltage $U_{load}(t)$ being reached when the resistance $R_{load}$ of the equipment is equal to the resistance $R_{battery}$ of the battery forming the source, such that the maximization routine (24) adapts said load voltage $U_{load}(t)$ so as to obtain:

$$U_{load}(t) = \frac{EMF_{battery}}{2.}$$

2. Method (18) according to claim 1,
**characterised in that** the method comprises a post-activation evaluation rule (25) for evaluating the quantity of electrical energy available from said at least one thermal battery (10) while it is in operation, said evaluation rule (25) supplies an energy percentage value T% at the current instant $t_{current}$ based on the remaining energy $E_{remaining}$ in said battery (10), the remaining energy $E_{remaining}$ being obtained by differentiating the initial energy $E_{initial}$ in said battery (10), differentiated from the measured activation instant $t_{activation}$ at the current instant $t_{current}$ for delivered energy $P_{delivered}(t)$ at the current instant $t_{current}$, where $P_{delivered}(t) = U_{load}(t_{current}) * I_{load}(t_{current})$ and according to the following formula:

$$E_{remaining} = E_{initial} - \int_{t_{activation}}^{t} P_{delivered}(t)\,dt$$

and then, based on the remaining energy $E_{remaining}$, said evaluation rule determines the time "$T_{remaining}$ at power P" as a function of the power P which is the power measured at the current instant $t_{current}$ and of a time "$T_{available.max}$" at maximum power which is specific to in said battery (10) as dimensioned, said evaluation rule (25) calculates the energy value T% based on the following formula:

$$T_{remaining\ at\ power\ P} = \frac{E_{remaining}}{P}$$

such that the energy value T% is:

$$T\% = \frac{T_{remaining\ at\ power\ P}}{T_{available.max.}} \times 100.$$

3. Method (18) according to one of claims 1 or 2,
   **characterised in that** the method (18) comprises an impedance reduction control law (27), such that on the activation of said least one battery (10), the internal resistance of the thermal battery, which diminishes progressively, is monitored during the duration of resistance reduction, which is comprised between 100 ms (milliseconds) and 3 seconds, the impedance reduction control law (27) verifying that the inrush current of power electronics of the converter of the electrical installation is suitable, such that the electrical installation (8) does not comprise a preload resistance for the purpose of limiting the inrush current.

4. Method (18) according to one of claims 1 to 3,
   **characterised in that** the method (18) comprises thermal monitoring (30) of said at least one thermal battery (10) and a thermal protection procedure (31) for keeping said at least one thermal battery (10) in a temperature range guaranteeing optimum supply of energy while ensuring that the structures of the aircraft (1) adjacent to said at least one thermal battery (10) are not exposed to heating comprised between 80°C and 110°C.

5. Method (18) according to one of claims 1 to 4,
   **characterised in that** the method is implemented for at least one piece of consuming equipment (9) from at least the following list: power plant (5), electric motorization system (11) of the aircraft (1), safety system (12) of the aircraft, system for assisting (13) the piloting of the aircraft, emergency information system (14) for the pilot of the aircraft.

6. Method (18) according to claim 5,
   **characterised in that** the method is implemented by at least one electric motorization system for assistance of a pilot of the rotary wing aircraft (1) during a phase of flight in autorotation, said electric motorization system (11) being supplied by an electrical energy storage system (17), said electric motorization system for assistance being incorporated in a hybrid power plant provided with said electric motorization system (11) and at least one thermal engine (6), the aircraft (1) comprising a main power transmission gearbox (16), said electrical energy storage system (17) on-board being electrically connected to said at least one thermal battery (10), the rotary wing aircraft (1) comprising a main rotor (2) which is driven, in flight, at a nominal speed of rotation by the hybrid power plant, such that during an inflight monitoring step (29) at least one monitoring parameter is measured in order to detect a possible failure of the thermal engine; such that if a failure is detected, said electrical motorization system (11) is operated to deliver auxiliary power for driving the main rotor in rotation, thereby enabling the pilot to be assisted during flight in autorotation following said failure.

7. Rotary wing aircraft configured according to the method (18) of one of claims 1 to 6,
   **characterised in that** said at least one thermal battery (10) incorporated in the electrical installation (8) is housed in at least one protective compartment (32) for providing protection against thermal radiation and anti-thermal confinement (33), and that at least one anti-thermal confinement (33) comprises a closed cover (34) on frame (35), with at least one thermal discharge vent (36).

8. Rotary wing aircraft according to claim 7,
**characterised in that** at least one thermal battery (10) is dedicated to providing low power electrical power, such that said usable power (21) is comprised between 20 watts to 300 watts.

9. Rotary wing aircraft according to claim 7,
**characterised in that** at least one thermal battery (10) is dedicated to providing high power electrical power, such that said usable power (21) is comprised between 50 kilowatts and 200 kilowatts.

10. Rotary wing aircraft according to claim 7,
**characterised in that** at least one thermal battery (10) is dedicated to providing electrical power for a power plant (5) of the aircraft (1), such that said usable power (21) is comprised between 5 kilowatts and 25 kilowatts, and for example between 10 kilowatts and 20 kilowatts.

## Fig.1

## Fig.2

## RÉFÉRENCES CITÉES DANS LA DESCRIPTION

**Documents brevets cités dans la description**

- EP 1059134 A
- FR 2994687
- FR 2997382
- FR 2952907
- WO 2012059671 A